# EUROPÄISCHE PATENTSCHRIFT

(11) **EP 0 572 465 B1**
(45) Veröffentlichungstag und Bekanntmachung des Hinweises auf die Patenterteilung: **21.02.1996**
(21) Anmeldenummer: 92904847.8
(22) Anmeldetag: 14.02.1992
(51) Int. Cl.: H01F 10/08, G01R 33/06

(54) **MEHRSCHICHTENSYSTEM FÜR MAGNETORESISTIVE SENSOREN UND VERFAHREN ZU DESSEN HERSTELLUNG**
MULTI-LAYER SYSTEM FOR USE IN MAGNETO-RESISTIVE SENSORS, AND A PROCESS FOR MANUFACTURING IT
SYSTEME MULTICOUCHE POUR PALPEURS MAGNETORESISTIFS ET PROCEDE POUR SA FABRICATION

(30) Priorität: 18.02.1991 DE 4104951
(43) Veröffentlichungstag der Anmeldung: 08.12.1993
(73) Patentinhaber: SIEMENS AKTIENGESELLSCHAFT, D-80333 München (DE)
(72) Erfinder: HUBERT, Alex, D-8520 Erlangen (DE); GRÜNBERG, Peter, D-5170 Jülich (DE); SCHEWE, Herbert, D-8522 Herzogenaurach (DE)
(86) Internationale Anmeldenummer: EP9200324
(87) Internationale Veröffentlichungsnummer: WO9215102

(56) Entgegenhaltungen:
- EP-A- 0 063 397
- EP-A- 0 346 817
- EP-A- 0 442 407
- PHYSICAL REVIEW, B. CONDENSED MATTER. Bd. 43, Nr. 1, Januar 1991, NEW YORK USSeiten 1297 - 1300; B.DIENY ET AL.: 'Giant magnetoresistan
- SOVIET PHYSICS TECHNICAL PHYSICS. Bd. 31, Nr. 6, Juni 1986, NEW YORK US Seiten714 - 716; N.F. KUBRAKOV ET AL.: 'Magnetoopti
- PHYSICAL REVIEW, B. CONDENSED MATTER. Bd. 42, Nr. 13A, 1. November 1990, NEWYORK US Seiten 8110 - 8120; J. BARNAS ET AL.: 'novel magnetoresistan
- PHYSICAL REVIEW, B. CONDENSED MATTER. Bd. 39, Nr. 7, 1. März 1989, NEW YORK USSeiten 4828 - 4830; G. BINASCH ET AL.: 'Enhan

## Beschreibung

Die Erfindung bezieht sich auf einen magnetoresistiven Sensor sowie auf ein Verfahren zu dessen Herstellung.

Der allgemeine Aufbau und die Funktionsweise von magnetoresistiven Sensoren mit Dünnfilmen aus ferromagnetischen Übergangsmetallen sind z.B. in der Veröffentlichung "Sensors", Vol. 5, 1989, Seiten 341 bis 380 näher erläutert. Die dort offenbarten, weitgehend magnetostriktionsfreien Schichten, die z.B. aus einer speziellen NiFe-Legierung mit 81 Gewichts-% Fe ("Permalloy") oder aus einer speziellen NiCo-Legierung mit 50 Gewichts-% Ni bestehen, zeigen jedoch nur einen verhältnismäßig geringen magnetoresistiven Effekt dR/R von etwa 2 bis 3 %. Man ist deshalb an einer Erhöhung dieses magnetoresistiven Effektes interessiert, um so Sensoren mit verbessertem Signal-Rausch-Verhältnis realisieren und den Einsatzbereich dieser Sensoren erweitern zu können.

Eine Erhöhung des magnetoresistiven Effektes konnte prinzipiell bei einigen Mehrschichtensystemen wie Co/Cu, Co/Cr und Fe/Cr nachgewiesen werden (vgl. z.B. "Phys. Rev. Lett.", Vol. 64, No. 19, 7.5.1990, Seiten 2304 bis 2307). Hierbei wird von der Tatsache ausgegangen, daß eine nicht-magnetische Zwischenschicht zwischen Schichten aus ferromagnetischem Material eine Austauschkopplung (Austauschwechselwirkung) zwischen den ferromagnetischen Schichten ermöglichen kann, falls die Dicke dieser Zwischenschicht einen vorbestimmten Wert im Nanometer-Bereich aufweist.

Diese Austauschkopplung ist für das magnetische Verhalten ("ferromagnetisch" oder "antiferromagnetisch") des Mehrschichtensystems verantwortlich. Bei den in der genannten Literaturstelle aus "Phys.Rev.Lett." erwähnten Mehrschichtensystemen wurde festgestellt, daß die Größe der Austauschkopplung als eine Funktion der Zwischenschichtdicke oszilliert und daß mehrere Bereiche existieren, für die die Kopplung antiferromagnetisch wird. Für praktische Anwendungen sind diese bisher bekannten Systeme allerdings kaum einsetzbar, da der maximale magnetoresistive Effekt nur in sehr hohen Magnetfeldern von mehreren 100 kA/m auftritt.

Eine Austauschkopplung zwischen Fe-Schichten über eine hinreichend dünne Cr-Zwischenschicht geht auch aus "Phys. Rev. B: Cond.Matt.", Vol. 42, No. 13a, 1.11.1990, Seiten 8110 bis 8120 hervor. Auch hier wurde festgestellt, daß diese Kopplung in Abhängigkeit von der Zwischenschichtdicke von ferromagnetisch zu antiferromagnetisch überwechseln kann. Bei einer Zwischenschichtdicke von 0,7 nm oder 1 nm herrscht im System Fe/Cr/Fe nur eine antiferromagnetische Kopplung zwischen den Fe-Schichten, während für eine über 2 nm dicke Zwischenschicht keine derartige Austauschkopplung mehr zu beobachten ist.

Auch in "Phys. Rev. B: Cond. Matt.", Vol. 43, No. 1, Pt. B, 1.1.1991, Seiten 1297 bis 1300, ist für Mehrschichtensysteme ein Übergang von einem ferromagnetischen zu einem antiferromagnetischen Verhalten der Mehrschichtensysteme beschrieben; hierbei soll jedoch ein äußeres Magnetfeld angelegt werden. Außerdem beschäftigt sich diese Veröffentlichung in erster Linie mit dem Auftreten eines erhöhten magnetoresistiven Effektes in Mehrlagensystemen aus nicht-gekoppelten ferromagnetischen Schichten wie z.B. aus NiFe, die in der Schichtebene anisotrop sind und durch ein nicht-magnetisches Metall wie z.B. Cu getrennt sind.

Die genannten Literaturstellen aus "Phys.Rev.Lett." und "Phys.Rev.B" setzen sich ausschließlich nur mit einer ferromagnetischen oder einer antiferromagnetischen Austauschkopplung auseinander, wobei in "Phys.Rev.B", Vol. 43 auch auf eine magnetostatische Streufeldkopplung bei verhältnismäßig großen Zwischenschichtdicken eingegangen ist. Mit diesen Literaturstellen wird jedoch kein Hinweis vermittelt, welche Wertebereiche der Zwischenschichtdicke und welche Art der Austauschkopplung für einen magnetoresistiven Sensor zugrundezulegen sind.

Aufgabe der vorliegenden Erfindung ist es deshalb, einen magnetoresistiven Sensor anzugeben, der bei Raumtemperatur und in niedrigen Feldern einen gegenüber bekannten Ausführungsformen erhöhten magnetoresistiven Effekt zeigt.

Diese Aufgabe wird erfindungsgemäß dadurch gelöst, daß ein Mehrschichtensystem mit mindestens zwei dünnen Schichten aus einem ferromagnetischen Material vorgesehen ist, zwischen denen (jeweils) eine dünne Zwischenschicht aus einem nicht-magnetischen Material angeordnet ist, wobei die Dicke der mindestens einen Zwischenschicht aus einem vorbestimmten Wertbereich ausgewählt ist, in dem ein Übergang zwischen einem ferromagnetischen Verhalten und einem antiferromagnetischen Verhalten des Mehrschichtensystems auftritt, derart ausgewählt ist, daß zwischen den ferromagnetischen Schichten eine Austauschkopplung in Form einer Spin-Kopplung von zumindest annähernd 90° gegeben ist.

Ein Bereich gemäß einer Schwankungsbreite von ± 10 %, insbesondere von ± 5 %, um den exakten Wert der so bestimmten Schichtdicke soll dabei vom Schutzumfang mit eingeschlossen sein.

Die Erfindung geht von der an sich bekannten Tatsache aus, daß die nicht-magnetische Zwischenschicht eine oszillierende Austauschkopplung (Austausch-Wechselwirkung) zeigt, die von der Dicke der Zwischenschicht abhängt (vgl. Beitrag BC 07 der "35th Annual Conference on Magnetism and Magnetic Materials" (MMM- Konferenz), San Diego, USA, 29.10. bis 1,11.1990). Das Vorzeichen der oszillierenden Austauschkopplung ist für das magnetische Verhalten (ferromagnetisch oder antiferromagnetisch) des Mehrschichtensystems verantwortlich. Sie kann in bekannter Weise z.B. durch Brillouin-Streuexperimente nachgewiesen werden. Der Erfindung liegt nun die Erkenntnis zugrunde, daß für den Sensor die Schichtdicke der nicht-magnetischen Zwischenschicht so zu wählen ist, daß die oszillierende Austausch-Wechselwirkung näherungsweise verschwindet, wobei die Kopplungskonstante A₁₂ (vgl. den genannten Beitrag der MMM-Konferenz) null wird. Dies ist dann der Fall, wenn das ferromagnetische Verhalten des Mehrschichtsystems (in Abhängigkeit von der Schichtdicke) in das antiferromagnetische Verhalten überwechselt (oder umgekehrt).

Prinzipiell ist es bekannt, daß man mit Mehrschichtensystemen mit nicht-kollinearen Spins der übereinanderliegenden ferromagnetischen Einzelschichten erhöhte magnetoresistive Effekte hervorrufen kann. Elektronen, die sich durch die nicht-magnetischen Zwischenschicht bewegen, erfahren nämlich dabei eine spinabhängige Streuung, die zu einem erhöhten magnetoresistiven Effekt führt. Erhöht man die Anzahl der aufeinanderfolgenden magnetischen und nicht-magnetischen Schichten, so vervielfacht sich der Streuprozeß und damit auch der magnetoresistive Effekt.

Bei Vorhandensein eines diskreten Überganges zwischen einem antiferromagnetischen und einem ferromagnetischen Verhalten des definierten Mehrschichtensystems ist zu beobachten, daß die Spins der übereinanderliegenden ferromagnetischen Schichten um etwa 90° gegeneinander verdreht sind. Es wurde erkannt, daß diese Spin-Konstellation eine optimale Konfiguration für eine Erhöhung des magnetoresistiven Effektes für einen Sensor ist, da das magnetische Gesamtmoment des Mehrschichtensystems nicht verschwindet und ein äußeres Magnetfeld leicht die Magnetisierung drehen und damit den Streuprozeß der Elektronen beeinflussen kann.

Ein weiterer Vorteil der erfindungsgemäßen Maßnahmen ist darin zu sehen, daß die Magnetisierungen der übereinanderliegenden Schichten mit dem elektrischen Strom einen Winkel von etwa 45° bilden, und daß man deshalb eine lineare Kennlinie des Sensors erhalten kann. Dies stellt eine erhebliche Verbesserung gegenüber den bekannten magnetoresistiven Sensoren dar, da die bisher erforderlichen aufwendigen Maßnahmen zu einer Linearisierung der Kennlinie dieser bekannten Sensoren durch ein transversales magnetisches Hintergrundfeld (Stützfeld) bzw. durch eine sogenannte "Barberpole"-Anordnung nunmehr entfallen können. Diese bekannten Linearisierungsmaßnahmen führten außerdem bisher zu einer unerwünschten Reduzierung der Empfindlichkeit eines entsprechenden Sensors. Diese Reduzierung der Empfindlichkeit ist nunmehr nicht mehr vorhanden.

Vorteilhafte Ausgestaltungen des Sensors nach der Erfindung mit einem Mehrschichtensystem gehen aus den entsprechenden Unteransprüchen hervor.

Ein besonders vorteilhaftes Verfahren zur Festlegung der Schichtdicke der zumindest einen Zwischenschicht aus dem nicht-magnetischen Material des erfindungsgemäßen Sensors ist dadurch gekennzeichnet, daß das Domänenmuster mit Hilfe des magnetooptischen Kerr-Effektes in Abhängigkeit von der Schichtdicke beobachtet wird. Der Nachweis einer verschwindenden Austausch-Wechselwirkung läßt sich nämlich besonders vorteilhaft durch Beobachtung des Domänenmusters bei Aufsicht auf die jeweils oberste ferromagnetische Schicht erbringen. Je nach magnetischem Verhalten (ferromagnetisch - antiferromagnetisch) zeigt nämlich das Mehrschichtensystem ein unterschiedliches Domänenmuster. Es wurde nun erkannt, daß dem diskreten Übergang(sbereich) zwischen dem ferromagnetischen Verhalten bzw. (Bereich) und dem antiferromagnetischen Verhalten (bzw. Bereich) des Mehrschichtsystems ein ganz spezielles Domänenmuster zugeordnet ist, das nur in diesem Übergangsbereich auftritt. Mit der Beobachtung dieses charakteristischen Domänenmusters kann somit sehr genau die zu wählende Schichtdicke festgelegt werden.

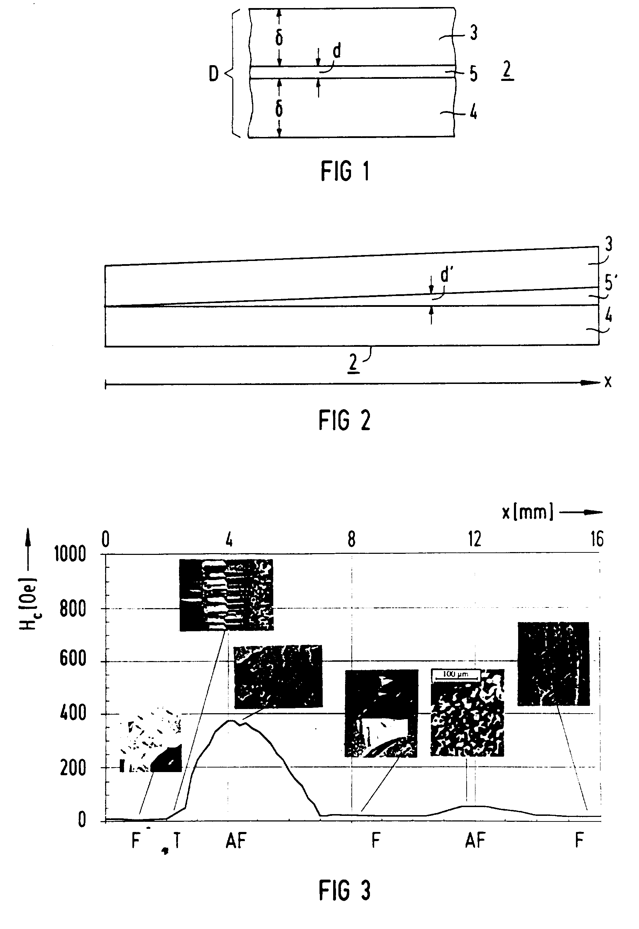

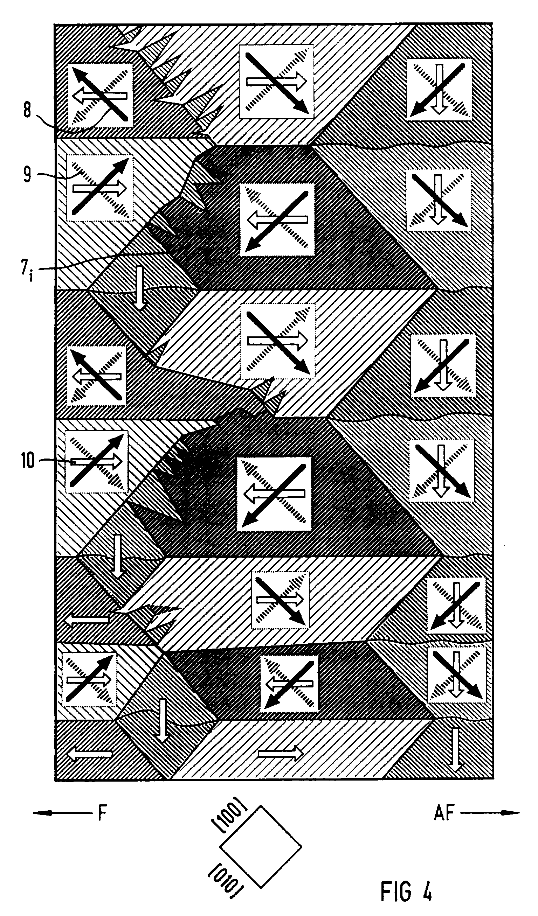

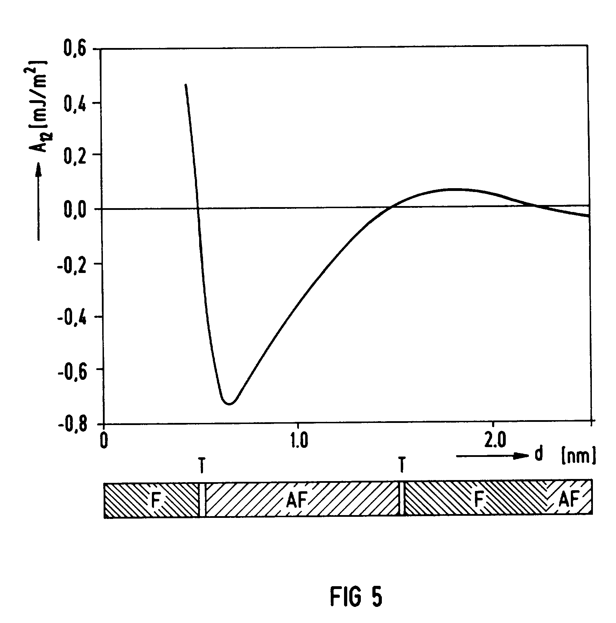

Die Erfindung wird nachfolgend anhand eines Ausführungsbeispieles noch weiter erläutert, wobei auf die schematische Zeichnung Bezug genommen wird. Dabei ist in Figur 1 der prinzipielle Aufbau eines Mehrschichtensystems eines erfindungsgemäßen Sensors dargestellt. Aus Figur 2 geht ein Testaufbau für dieses Mehrschichtensystem hervor. Die Figuren 3 und 5 zeigen jeweils in einem Diagramm die Koerzitivfeldstärke bzw. die Kopplungskonstante eines Mehrschichtensystems in Abhängigkeit von der Dicke seiner Zwischenschicht. In Figur 4 ist ein für das erfindungsgemäße Mehrschichtensystem charakteristisches Domänenbild veranschaulicht.

Der erfindungsgemäße magnetoresistive Sensor mit einem Mehrschichtensystem aus Dünnfilmen zeichnet sich insbesondere durch eine erhöhte Empfindlichkeit aus. Sein Mehrschichtensystem weist mindestens zwei, vorzugsweise mehr als zwei dünne Schichten aus einem ferromagnetischen Material auf. Bei diesem Material kann es sich insbesondere um die Übergangsmetalle Ni, Co oder Fe oder um eine Legierung mit diesen Elementen handeln, wobei auch nicht-metallische Verunreinigungen oder Zusätze zu einem geringen Anteil mit enthalten sein können. Vorteilhaft sind Materialien mit einer sehr kleinen Magnetostriktion. Diese ferromagnetischen Schichten sind untereinander jeweils durch dünne Zwischenschichten getrennt. Diese Zwischenschichten sollen aus einem nicht-magnetischen Material wie z.B. aus elementarem Cr, Cu, Mn, Ru, Au oder V aus Legierungen mit diesen Elementen (unter Einschluß geringer Zusätze oder Verunreinigungen) hergestellt werden. Es ergibt sich so ein sandwichartiger Aufbau eines Mehrschichtensystems aus alternierend ferromagnetischen und nicht-magnetischen Schichten. Einzelne Kombinationen für die zu wählenden Materialien entsprechender Mehrschichtensysteme sind z.B. in dem genannten Beitrag BC 07 der MMM-Konferenz aufgeführt.

Gemäß dem in Figur 1 dargestellten schematischen Schnitt weist ein allgemein mit 2 bezeichnetes Mehrschichtensystem des erfindungsgemäßen Sensors zwei äußere ferromagnetische Schichten 3 und 4, z.B. aus Fe, sowie eine dazwischenliegende nicht-magnetische Zwischenschicht 5, z.B. aus Cr, auf. Die Dicke der ferromagnetischen Schichten 3 und 4 liegt im allgemeinen zwischen 1 und 100 nm und beträgt beispielsweise 10 nm. Dabei können für die beiden ferromagnetischen Schichten 3 und 4 auch unterschiedliche Schichtdicken vorgesehen werden. Die Dicke d der Zwischenschicht 5 ist erfindungsgemäß so gewählt, daß das Mehrschichtensystem 2 einen erhöhten magnetoresistiven Effekt zeigt. Die Gesamtdicke D des gesamten Mehrschichtensystems sollte dabei nicht größer als die mittlere freie Weglänge der Elektronen in dem System gewählt werden.

Um die exakte Größe der Schichtdicke d der Zwischenschicht 5 festlegen zu können, muß z.B. mittels eines besonderen Vorversuchs das magnetische Verhalten des Mehrschichtensystems in Abhängigkeit von der Schichtdicke untersucht werden. Hierzu wird gemäß Figur 2 ein Mehrschichtensystem 2' aus den ferromagnetischen Schichten 3 und 4, z.B. aus Fe, und einer dazwischenliegenden nicht-magnetischen Zwischenschicht 5' , z.B. aus Cr, erstellt. Der Aufbau der Cr-Zwischenschicht 5' ist dabei in dem gezeigten Schnitt keilförmig, das heißt, die Dicke d' dieser Schicht nimmt in Richtung einer Koordinate x kontinuierlich zu. Es ergibt sich so ein im Schnitt keilförmiger Aufbau der Zwischenschicht 5'. Dabei sei angenommen, daß der gezeigte Keil an seiner Spitze (x = 0) die Dicke d' = 0 und an seinem gegenüberliegenden Ende die Dicke d' = 3,7 nm hat. Die einkristallinen Fe-Schichten 3 und 4 können dabei eine Dicke δ von 10 nm oder auch darunter haben.

Die einzelnen Schichten des Mehrschichtensystems 2'lassen sich in bekannter Weise z.B. durch ein Molekular-Strahl-Epitaxie-Verfahren, durch Verdampfen oder durch Sputtern erzeugen. Zur Herstellung der sehr dünnen Cr-Schicht 5' kann mit Hilfe einer Blende, die während der Cr-Deposition mit vorgegebenener Geschwindigkeit über die zu beschichtende Unterlage in Form der Fe-Schicht 3 bewegt wird, ein keilförmiger Aufbau mit sehr geringem Keilwinkel erzeugt werden. Dieses Verfahren läßt sich noch dahingehend verbessern, daß man zunächst eine z.B. 0,5 nm dicke Cr-Schicht niederschlägt und erst dann mit der Herstellung des sehr flachen Keils beginnt.

Eine sehr niedrige Depositionsrate ist vorteilhaft, da sie die Steuerung der Schichtabscheidung erleichtert. Dies kann durch Verwendung einer mit Schlitzen oder Löchern versehenen Blende erreicht werden. Für eine gleichmäßige Beschichtung sorgt dann eine Bewegung dieser Blende oder der zu beschichtenden Unterlage.

Eine weitere Möglichkeit, um eine niedrige Depositionsrate und eine geringe Wärmebelastung der zu beschichtenden Unterlage zu erreichen, bieten sogenannte "Facing Target Type Sputtering"-Systeme (vgl. "IEEE Trans. Magn.", Vol. MAG-16, 1980, Seiten 646 bis 648). Darüber hinaus sind Verfahren bekannt, um Schichten mit einer definierten Anzahl von Atomlagen abzuscheiden und zu analysieren (vgl. "IEEE Trans. Magn.", Vol. MAG-20, 1984, Seiten 1840 bis 1845).

Nach Fertigstellung des Mehrschichtensystems 2' kann man nun in bekannter Weise (vgl. z.B. "IEEE Trans. Magn.", Vol. MAG-21, 1985, Seiten 1596 bis 1598) durch magnetooptische Betrachtung der Domänen einen verhältnismäßig breiten Bereich identifizieren, in dem die oszillierende Austauschkopplung verschwindet und der für magnetoresistive Sensoren besonders geeignet ist. Figur 3 zeigt in Abhängigkeit von der Größe x (in mm) der Längsausdehnung der Zwischenschicht 5' die auf magnetooptischem Wege bestimmte Koerzitivfeldstärke H_{c} (in 0e ≈ 79, 6 A/m). Dabei sind charakteristischen Stellen der Meßkurve die zu beobachtenden Domänenbilder zugeordnet. Diese Bilder wurden bei Remanenz nach Sättigung des Mehrschichtensystems 2' längs der sogenannten "schweren Richtung" der Magnetisierung quer zur Ausdehnungsrichtung des Mehrschichtensystems gemessen. Die Bereiche niedriger Koerzitivfeldstärke sind durch verhältnismäßig weite Domänenmuster charakterisiert, wobei die Domänenwände parallel und unter einem Winkel von etwa 45° zu der sogenannten "leichten Richtung", d.h. in [100]- und [010] -Richtungen orientiert sind. Die Bereiche erhöhter Koerzitivfeldstärke sind durch unregelmäßig geformte Domänen gekennzeichnet. Sie lassen sich so deuten, daß in den entsprechenden Teilen des Mehrschichtensystems die antiferromagnetische Kopplung überwiegt. Wenn jedoch in dem Mehrschichtensystem die benachbarten Schichten an jeder Stelle entgegengesetzt zueinander magnetisiert sind, verschwindet ihr magnetisches Gesamtmoment. Dann ist theoretisch jede beliebige Orientierung einer Domänenwand möglich, und die tatsächliche Domänengestalt wird durch andere Randbedingungen bestimmt.

Gemäß Figur 3 sind drei durch "F" gekennzeichnete ferromagnetisch gekoppelte Bereiche und zwei durch "AF" gekennzeichnete antiferromagnetisch gekoppelte Bereiche des Mehrschichtsystems 2' zu identifizieren. Außerdem ist ein Domänenmuster von einem mit "T" bezeichneten Übergangsbereich zwischen einem ferromagnetischen und einem antiferromagnetischen Bereich wiedergegeben. Dieses Domänenmuster ist ganz charakteristisch für diesen Bereich und erlaubt somit ein exaktes Festlegen der zugehörigen Dicke d der nicht-magnetischen Zwischenschicht 5, wobei Schwankungsbreiten von ± 10 %, vorzugsweise von höchstens ± 5 %, um den exakten Wert der Dicke d zulässig sind. Gemäß dem gewählten Ausführungsbeispiel mit jeweils zwei 10 nm dicken Fe-Schichten 3 und 4 ergibt sich für die Schichtdicke d einer Cr-Zwischenschicht 5 ein Wert von 0,5 ± 0,02 nm. Im allgemeinen liegen die Schichtdicken d unter 2 nm, insbesondere unter 1 nm.

Das sich bei magnetooptischer Betrachtung der obersten magnetischen (Fe-)Schicht des Mehrschichtensystems Fe/Cr/Fe ergebende, für den Übergangsbereich T charakteristische Domänenmuster der Figur 3 ist in Figur 4 vergrößert wiedergegeben. Die in dieser Figur an den einzelnen, allgemein mit 7ᵢ (1 < i < ...) bezeichneten Domänen angebrachten Pfeile 8, 9 und 10 sollen dabei Magnetisierungsrichtungen veranschaulichen, die den folgenden Teilen des in Figur 1 angedeuteten Mehrschichtensystems 2 zuzuordnen sind: Die voll durchgezogenen Pfeile 8 geben die Magnetisierungsrichtungen der Domänen in der oberen magnetischen (Fe-)Schicht 3 wieder, während die schraffierten Pfeile 9 zu der unteren magnetischen (Fe-) Schicht 4 gehören. Der offene Pfeil 10 stellt die Gesamtmagnetisierung des Mehrschichtensystems 2 im Bereich der jeweiligen Domäne 7ᵢ dar. In der Figur sind ferner die [100]- und [010]-Richtungen von Kristallachsen eingetragen, in die sich die Domänenwände in charkteristischer Weise erstrecken.

Die Ausdehnung der ferromagnetischen Bereiche F, der antiferromagnetischen Bereiche AF sowie die der Übergangsbereiche T sind in Figur 5 näher als Balkendiagramm veranschaulicht. In der Figur ist ferner in einem zugeordneten Diagramm die spektroskopisch gemessene Kurve der Kopplungskonstanten A₁₂ (in mJ/m) in Abhängigkeit von der Schichtdicke d (in Å) wiedergegeben (vgl. den genannten Beitrag BC 07 der MMM-Konferenz). Die Schnittpunkte der Kurve der Kopplungskonstanten mit der Achse A₁₂ = 0 legt jeweils den übergangsbereich T zwischen ferromagnetischem und antiferromagnetischem Verhalten des Mehrschichtsystems und damit auch den konkreten Wert der zu wählenden Schichtdicke d fest. Während der erste Übergangsbereich T (mit kleinstem Wert von d) klar zu unterscheiden ist, sind die späteren Übergangsbereiche T schwieriger zu bestimmen; denn dort sind die Kopplungseffekte schwach und die Domänen sind eher durch Koerzitivfeldstärkeeffekte als durch Energieminimierung festgelegt.

Sind erst einmal, wie vorstehend geschildert, die einzelnen Domänenmuster bekannt, so kann man den korrekten Aufbau eines Mehrschichtensystems nach der Erfindung bei Aufsicht auf die jeweils oberste ferromagnetische Schicht des Systems direkt durch Beobachtung des Domänenmusters mit Hilfe des magnetooptischen Kerr-Effektes innerhalb einer entsprechenden Depositionsapparatur kontrollieren. Damit ist eine Erhöhung der Fertigungsqualität verbunden, insbesondere wenn eine Sequenz z.B. des Mehrschichtensystems Fe/Cr/Fe/Cr/Fe ... mit vielen Schichten hergestellt werden soll und die jeweils oberste Fe-Schicht des Mehrschichtensystems untersucht wird.

Das Erreichen einer gewünschten Schichtdicke läßt sich auch durch Messung der- Hysteresiskurve des jeweiligen Mehrschichtensystems nachweisen.

Als weiterer Vorteil des Mehrschichtensystems nach der Erfindung ist die vergleichsweise niedrige Sättigungsfeldstärke Hₛ, die zu erreichen ist, zu nennen. Für das vorstehend angedeutete Ausführungsbeispiel eines Mehrschichtensystems 2 aus zwei 10 nm dicken FE-Schichten 3 und 4 und einer 0,2 nm dicken Cr-Zwischenschicht 5 beträgt Hₛ nur etwa 40 kA/m. Dies bedeutet, daß mit entsprechenden Mehrschichtensystemen magnetoresistive Sensoren sehr großer Empfindlichkeit herstellbar sind.

## Patentansprüche

1. Magnetoresistiver Sensor mit einem Mehrschichtsystem (2), das mindestens zwei dünne Schichten (3, 4) aus einem ferromagnetischen Material aufweist, zwischen denen (jeweils) eine dünne zwischenschicht (5) aus einem nicht-magnetischen Material angeordnet ist, wobei die Dicke (d) der mindestens einen zwischenschicht (5) aus einem vorbestimmten Wertebereich, in dem ein Übergang zwischen einem ferromagnetischen Verhalten und einem antiferromagnetischen Verhalten des Mehrschichtensystems (2) auftritt, derart ausgewählt ist, daß zwischen den ferromagnetischen Schichten (3, 4) eine Austauschkopplung in Form einer Spin-Kopplung von zumindest annähernd 90° gegeben ist.

2. Sensor nach Anspruch 1, **gekennzeichnet** durch einen sandwichartigen Aufbau aus mehr als zwei ferromagnetischen Schichten mit jeweils dazwischenliegender nicht-magnetischer Zwischenschicht.

3. Sensor nach Anspruch 1 oder 2, **dadurch gekennzeichnet,** daß als Material für die ferromagnetischen Schichten (3, 4) ein Element aus der Gruppe der Übergangsmetalle Ni, Fe, Co, oder eine Legierung mit mindestens einem dieser Elemente vorgesehen ist.

4. Sensor nach einem der Ansprüche 1 bis 3, **dadurch gekennzeichnet,** daß als Material für die mindestens eine nicht-magnetische Zwischenschicht (5) ein Element aus der Gruppe der Metalle Cr, Cu, Ru, Au, Mn, V oder eine Legierung mit mindestens einem dieser Elemente vorgesehen ist.

5. Sensor nach einem der Ansprüche 1 bis 4, **dadurch gekennzeichnet,** daß die ferromagnetischen Schichten (3, 4) eine Dicke (δ) von jeweils 1 bis 100 nm haben.

6. Sensor nach einem der Ansprüche 1 bis 5, **dadurch gekennzeichnet,** daß die mindestens eine nicht-magnetische Zwischenschicht (5) eine Dicke (d) unter 2 nm, insbesondere unter 1 nm hat.

7. Verfahren zur Herstellung des Sensors nach einem der Ansprüche 1 bis 6, **dadurch gekennzeichnet,** daß zur Festlegung der Schichtdicke (d) der mindestens einen Zwischenschicht (5) aus dem nicht-magnetischen Material das Domänenmuster mit Hilfe des magnetooptischen Kerr-Effektes in Abhängigkeit von der Schichtdicke (d, d') beobachtet wird.

## Claims

1. Magnetoresistive sensor with a multilayer system (2) having at least two thin layers (3, 4) of a ferromagnetic material, between which a (respective) thin intermediate layer (5) of a non-magnetic material is arranged, whereby the thickness (d) of the at least one intermediate layer (5) of a predetermined value range, in which a transition occurs between a ferromagnetic behaviour and an antiferromagnetic behaviour of the multilayer system (2), is selected in such a way that between the ferromagnetic layers (3, 4) there is an exchange coupling in the form of a spin coupling of at least approximately 90°.

2. Sensor according to claim 1, characterized by a sandwich-like structure of more than two ferromagnetic layers with in each case a non-magnetic intermediate layer lying between them.

3. Sensor according to claim 1 or 2, characterized in that an element of the group of the transition metals Ni, Fe, Co or an alloy with at least one of these elements is provided as material for the ferromagnetic layers (3, 4).

4. Sensor according to one of claims 1 to 3, characterized in that an element from the group of metals Cr, Cu, Ru, Au, Mn, V or an alloy with at least one of these elements is provided as material for the at least one non-magnetic intermediate layer (5).

5. Sensor according to one of claims 1 to 4, characterized in that the ferromagnetic layers (3, 4) have a thickness (δ) of in each case 1 to 100 nm.

6. Sensor according to one of claims 1 to 5, characterized in that the at least one non-magnetic intermediate layer (5) has a thickness (d) less than 2nm, in particular less than 1 nm.

7. Method to produce the sensor according to one of claims 1 to 6, characterized in that to ascertain the layer thickness (d) of the at least one intermediate layer (5) from the non-magnetic material the domain pattern is observed as a function of the layer thickness (d, d') with the aid of the magnetooptic Kerr effect.

## Revendications

1. Capteur magnétorésistif avec un système multicouche (2) présentant au moins deux couches minces (3, 4) composées d'un matériau ferromagnétique, entre lesquelles (selon le cas) est disposée une mince couche intermédiaire (5) composée d'un matériau non-magnétique, où l'épaisseur (d) de la - au moins une - couche intermédiaire (5) est sélectionnée dans une échelle de valeurs prédéfinies, dans laquelle intervient une transition entre un comportement ferromagnétique et un comportement antiferromagnétique du système multicouche (2), de telle porte qu'entre les couches ferromagnétiques (3, 4) un couplage d' échange existe sous la forme d'un couplage-spin d'au moins 90° environ.

2. Capteur selon la revendication 1, caractérisé par une structure-sandwich composée de plus de deux couches ferromagnétiques avec selon le cas une couche intermédiaire non-magnétique entre celles-ci.

3. Capteur selon la revendication 1 ou 2, caractérisé en ce que comme matériau pour les couches ferromagnétiques (3, 4) est prévu un élément du groupe des métaux transitoires Ni, Fe, Co ou un alliage avec au moins l'un de ces éléments.

4. Capteur selon l'une des revendications 1 à 3, caractérisé en ce que comme matériau pour la - au moins une - couche intermédiaire non-magnétique (5) est prévu un élément du groupe des métaux Cr, Cu, Ru, Au, Mn, V ou un alliage avec au moins l'un de ces éléments.

5. Capteur selon l'une des revendications 1 à 4, caractérisé en ce que les couches ferromagnétiques (3, 4) ont une épaisseur (δ) de 1 à 100 nm selon le cas.

6. Capteur selon l'une des revendications 1 à 5, caractérisé en ce que la - au moins une - couche intermédiaire non-magnétique (5) a une épaisseur (d) inférieure à 2 nm, en particulier inférieure à 1 nm.

7. Procédé pour la fabrication du capteur selon l'une des revendications 1 à 6, caractérisé en ce que, pour définir l'épaisseur de la couche (d) d'au moins une couche intermédiaire (5) composée d'un matériau non-magnétique, le dessin des domaines est observé au moyen de l'effet Kerr magnéto-optique en fonction de l'épaisseur de la couche (d, d').
